# EUROPÄISCHE PATENTSCHRIFT

(11) **EP 1 360 766 B1**
(45) Veröffentlichungstag und Bekanntmachung des Hinweises auf die Patenterteilung: **14.06.2006**
(21) Anmeldenummer: 01913703.3
(22) Anmeldetag: 15.02.2001
(51) Int. Cl.: H03K 19/003

(54) **HOCHGESCHWINDIGKEITSAUSGANGSTREIBER**
HIGH -SPEED OUTPUT DRIVER
ETAGE DE SORTIE A GRANDE VITESSE

(43) Veröffentlichungstag der Anmeldung: 12.11.2003
(73) Patentinhaber: Infineon Technologies AG, 81669 München (DE)
(72) Erfinder: SCHRÖDINGER, Karl, 14089 Berlin (DE)
(74) Vertreter: Müller, Wolfram Hubertus
(86) Internationale Anmeldenummer: PCT/DE2001/000660
(87) Internationale Veröffentlichungsnummer: WO 2002/065641

(56) Entgegenhaltungen:
- EP-A- 0 463 316
- EP-A- 0 999 643
- US-A- 4 719 369
- US-A- 5 581 197
- US-A- 5 621 335
- US-A- 6 060 907

## Beschreibung

Die Erfindung betrifft einen Hochgeschindigkeitsausgangstreiber nach dem Oberbegriff des Anspruchs 1. Derartige Hochgeschwindigkeitstreiber dienen insbesondere der Verbindung zweier digitaler Schaltungen über Wellenleiter, insbesondere 50-Ohm-Leitungen oder 75-Ohm-Leitungen. Sie sind in CMOS-Schaltungen mit vorzugsweise kleinen Versorgungsspannungen (< 2,5 Volt) ausgebildet.

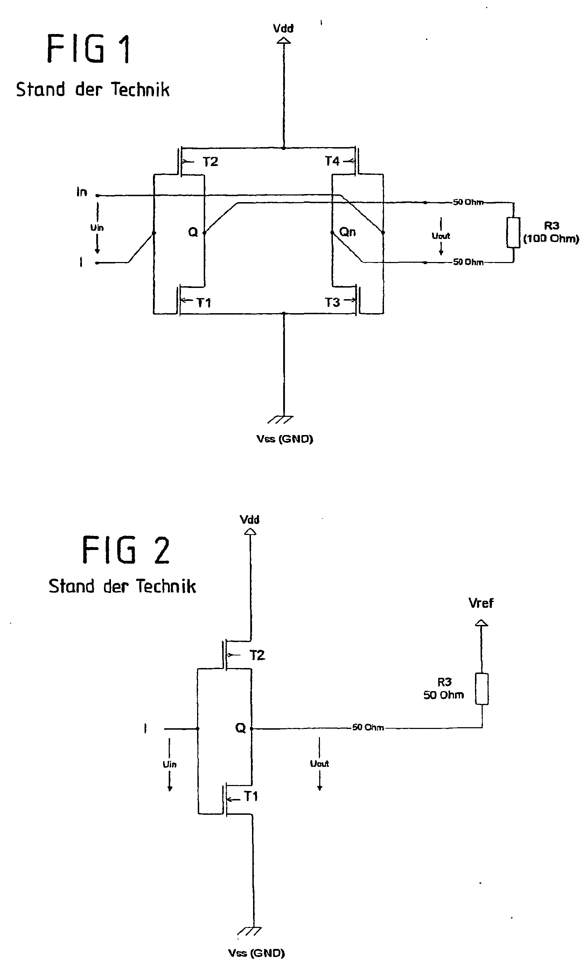

Ein Grundelement derartiger Hochgeschwindigkeitsausgangstreiber ist ein differenzieller Treiber oder ein "single ended" Treiber gemäß den Figuren 1 und 2. Gemäß Figur 1 weist ein differenzieller Treiber zwei Standard-CMOS-Inverter mit n-Kanal MOS-Transistoren T1, T3 und komplementären p-kanal MOS-Transistoren T2, T4 auf. Die beiden Inverter werden mit über Eingangsknoten I, In mit einer differentiellen Eingangsspannung Uin betrieben. An den Knotenpunkten Q, Qn der Drain-Anschlüsse der beiden Inverter wird die Ausgangsspannung Uout abgenommen. Am Ausgang Q, Qn liegt eine differentielle Last R3 von üblicherweise 2x50 Ohm = 100 Ohm an. Ein solcher differenzieller Treiber stellt einen Gegentaktausgang zur Verfügung.

Ein "single ended" Treiber gemäß Figur 2 weist einen Standard-CMOS-Inverter mit einem n-Kanal-MOS-Transistor T1 und einem p-Kanal-MOS-Transistor T2 auf, die in Reihe geschaltet sind. Der CMOS-Inverter arbeitet auf eine Last R3 von üblicherweise 50 Ohm, an der eine Referenzspannung Vref liegt. Die Referenzspannung Vref entspricht beispielsweise der halben Versorgungsspannung (Eintaktausgang).

Die in den Figuren 1 und 2 dargestellten Schaltungen stellen prinzipielle Schaltungen dar, welche für den konkreten Anwendungsfall durch Dimensionierung die geforderten Eigenschaften erhalten. Insbesondere werden die Drain-Source-Widerstände der Transistoren entsprechend der gewünschten Anwendung eingestellt.

Ein Nachteil an den bekannten CMOS-Invertern bzw. Treiber besteht allerdings darin, daß die Transistoreigenschaften hohen Schwankungen unterworfen sind. Diese Schwankungen ergeben sich insbesondere aus Temperaturschwankungen und aus Parameterschwankungen beim Herstellungsprozeß. Die Eigenschaften der Transistoren der CMOS-Inverter unterliegen somit hohen Schwankungen über der Temperatur und dem Herstellungsprozeß. Diese Schwankungen können in den beschriebenen Anwendungen bei bis zu 100 Prozent liegen.

Andererseits besteht für die genannten Hochgeschwindigkeitsausgangstreiber das Erfordernis, daß diese
1. an einer externen Last, etwa einer 50-Ohm-Leitung mit Abschlußwiderstand, einen konstanten Ausgangspegel, d.h. einen relativ konstanten Ausgangsstrom aufweisen und
2. der Treiber einen relativ konstanten Ausgangswiderstand aufweist, um Reflektionen an der Quelle zu vermeiden. Der Treiber sollten dabei möglichst eine aktive Last in Form eines schaltenden Transistors aufweisen, da passive Lasten den Stromverbrauch erhöhen bzw. bei kleinen Spannung nicht einsetzbar sind.

Die beiden vorgenannten Forderungen lassen sich mit herkömmlichen CMOS-Invertern aufgrund der erläuterten Schwankungen der Transistoreigenschaften über Temperatur und Herstellungsprozeß nicht verwirklichen. Es besteht daher ein Bedürfnis, die bekannten CMOS-Inverter bzw. Treiberschaltungen mit derartigen Invertern derart weiterzubilden, daß konstante Ausgangsbedingungen, d.h. ein im wesentlichen konstanter Ausgangsstrom und ein im wesentlichen konstanter Ausgangswiderstand des Treibers vorliegen.

In der Veröffentlichung "Itanium^{™} Processor System Bus Design" A. Ilkbahar, S. Venkataraman, H. Muljono, ESSCIRC 2000, Stockholm 19.-21. September 2000, S. 128 - 131 ist eine Ausgangstreiberschaltung für den Itanium^{™}-Processor der Firma Intel beschrieben, bei der einem Inverter zur Einstellung einer gewünschten Ausgangsimpedanz diskret parallele Inverter zugeschaltet werden. Jedoch erfolgt dies im Hinblick auf eine Anpassung des Treibers an variable kapazitive Ausgangslasten.

Aus der US-A-5 621 335 ist ein gattungsgemäßer Hochgeschwindigkeitstreiber bekannt. Einem CMOS Inverter mit einem n-Kanal Transistor und einem dazu in Reihe geschalteten, komplementären p-Kanal Transistor sind digital weitere CMOS Inverter zuschaltbar.

Die US-A-5 581 197 beschreibt einen CMOS Ausgangstreiber mit einem CMOS-Inverter, dem Transistoren durch analoge Steuersignale in Reihe zugeschaltet werden, um den Ausgangswiderstand des Treibers konstant zu halten.

Der vorliegenden Erfindung liegt die Aufgabe zugrunde, einen weiteren Hochgeschwindigkeitsausgangstreiber mit einem als Verstärker für digitale Signale dienenden CMOS-Inverter zur Verfügung zu stellen, der sich durch einen im wesentlichen konstanten Ausgangsstrom und einen im wesentlichen konstanten Ausgangswiderstand auszeichnet.

Diese Aufgabe wird erfindungsgemäß durch einen Hochgeschwindigkeitsausgangstreiber mit den Merkmalen des Anspruchs 1 gelöst. Vorteilhafte und bevorzugte Ausgestaltungen der Erfindung sind in den Unteransprüchen angegeben.

Es sind zusätzliche Transistoren vorgesehen, die die Schaltungsmittel zur Steuerung oder Regelung des Ausgangsstroms und des Ausgangswiderstands des Treibers dem CMOS-Inverter über analoge Steuersignale in Reihe zuschalten, wobei mindestens ein zusätzlicher Transistor in Reihe mit dem n-Kanal Transistor und mindestens ein zusätzlicher Transistor in Reihe mit dem p-Kanal Transistor des Inverters geschaltet ist. Erfindungsgemäß ist dabei für jeden zusätzlichen Transistor eine gesonderte, unabhängige Regelschaltung in Form einer geregelten Spiegelschaltung vorgesehen, die den Arbeitspunkt des jeweiligen zusätzlichen Transistors regelt.

Zur Regelung (mit Rückkopplung) werden somit analog zusätzliche Transistoren zugeschaltet, die die Ausgangseigenschaften des Treibers verändern, insbesondere dessen Drain-Source-Widerstand. Das Zuschalten von einzelnen Transistoren zur Änderung der Ausgangseigenschaften des Treibers erfolgt über eine analoge Steuerung.

Die zugeschalteten Transistoren werden bevorzugt jeweils im Triodenbereich betrieben, in dem ein Transistor einen linearen Widerstand darstellt. Der durch den Transistor zusätzlich zur Verfügung gestellte Widerstand ist in diesem Bereich im wesentlichen linear von der am Gate-Anschluß anliegenden Spannung abhängig.

Die Elemente der Spiegelschaltung entsprechen bevorzugt in ihrer Größe den Elementen der Treiberschaltung oder sind gegenüber letzteren um einen bestimmten Wert skaliert. Durch eine Skalierung um den Faktor n kann die Stromaufnahme um den Faktor 1/n reduziert werden.

Die Spiegelschaltung enthält bevorzugt einen Operationsverstärker, der die Steuerspannung für die Spiegelschaltung auf einen Wert derart regelt, daß sich der gewünschte Ausgangspegel am Ausgang der Spiegelschaltung und damit auch am Ausgang des Treibers einstellt.

Die Erfindung wird nachfolgend unter Bezugnahme auf die Figuren der Zeichnung anhand mehrerer Ausführungsbeispiele näher erläutert. Es zeigen:
- Figur 1 -: einen differentiellen Ausgangstreiber gemäß dem Stand der Technik;
- Figur 2 -: einen "single ended" Ausgangstreiber gemäß dem Stand der Technik;
- Figur 3 -: ein erstes Ausführungsbeispiel eines digital geschalteten, erfindungsgemäßen Treibers mit Steuerung der Gate-Anschlüsse;
- Figur 4 -: ein zweites Ausführungsbeispiel eines digital geschalteten, erfindungsgemäßen Treibers mit Steuerung der Source-Anschlüsse;
- Figur 5 -: ein Ausführungsbeispiel eines erfindungsgemäßen Treibers mit analoger Steuerung;
- Figur 6 -: eine digitale Steuereinheit für einen erfindungsgemäßen Ausgangstreiber;
- Figur 7 -: eine analoge Steuereinheit für einen erfindungsgemäßen Ausgangstreiber und
- Figur 8 -: zwei Spiegelschaltungen zur Regelung der Steuerspannungen des Treibers der Figur 5.

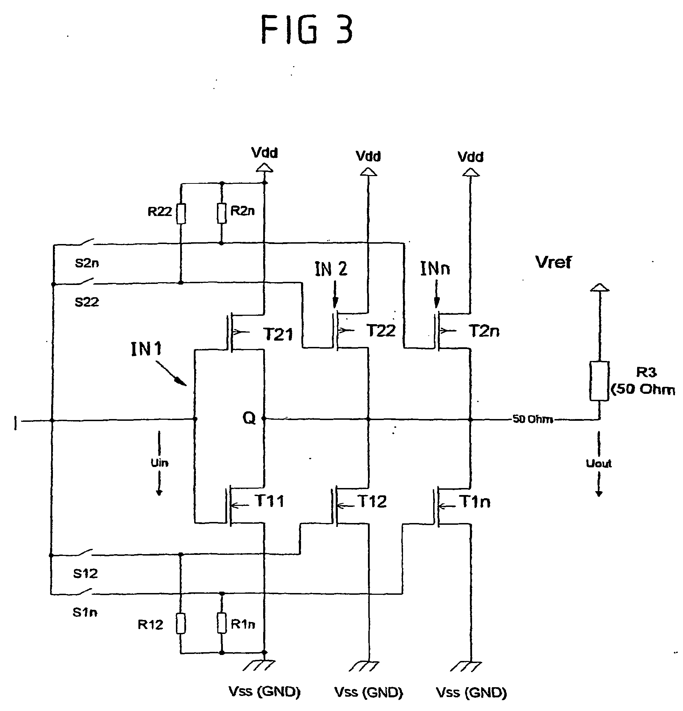

Die prinzipiellen Grundschaltungen eines erfindungsgemäßen Hochgeschwindigkeitsausgangstreibers waren eingangs anhand der Figuren 1 und 2 erläutert worden. Es wird darauf hingewiesen, daß die nachfolgenden Ausführungsbeispiele der Figuren 3 bis 8 Schaltungsvarianten betreffen, in denen eine Eintaktschaltung gemäß Figur 2 verwendet wird. Die nachfolgenden Ausführungsbeispiele sind jedoch in entsprechender Weise ebenfalls für differentielle Schaltungen gemäß Figur 1 anwendbar, da diese grundsätzlich symmetrisch aufgebaut sind.

Gemäß Figur 3 ist ein erster Inverter IN1 vorgesehen, der aus einem p-Kanal MOS-Transistor T21 und einem n-Kanal MOS-Transistor T11 besteht, die komplementär ausgebildet und in Reihe geschaltet sind. An einem Eingangsknoten I liegt ein digitales Eingangssignal Uin an und an einem Ausgangsknoten Q wird ein ebenfalls digitales Ausgangssignal abgegriffen. Der Transistor T11 ist mit seinem Source-Anschluß mit dem Bezugspotential Vss (GROUND) und der Transistor T21 mit seinem Source-Anschluß mit der Betriebsspannung Vdd verbunden.

Wenn an dem Eingangsknoten I die Eingangsspannung LOW anliegt, sperrt der Transistor T11 und wird der Ausgang Q auf die Betriebsspannung Vdd gezogen. Wenn dagegen die Eingangsspannung am Eingangsknoten I den Wert HIGH annimmt, sperrt der obere Transistor T21 und wird der Ausgang Q auf Ground gezogen. Derartige CMOS-Inverter sind an sich bekannt.

Erfindungsgemäß sind nun hinter den Ausgang Q des ersten Inverters IN1 weitere Inverter IN2 bis INn geschaltet, die Transistoren T12, T22 bzw. T1n, T2n aufweisen und parallel zum Inverter IN1 angeordnet sind. Grundsätzlich können dabei eine beliebige Zahl von zusätzlichen Invertern zugeschaltet sein, wobei in Figur 3 lediglich zwei zusätzliche Inverter IN2, INn dargestellt sind.

Die Gate-Anschlüsse der Transistoren der weiteren Inverter IN2, INn liegen ebenso wie die Gate-Anschlüsse der Transistoren des Inverters IN1 am Bezugspunkt I und damit an der Eingangsspannung Uin. Die Verbindung erfolgt allerdings über Schalter S12, S1n, S22, S2n, über deren Steuerung die Zuschaltung der weiteren Inverter IN2 bis INn steuerbar ist.

Die Gate-Anschlüsse der Transistoren der weiteren Inverter IN2, INn sind über Widerstände R22, R2n bzw. R12, R1n mit der Betriebsspannung Vdd bzw. GROUND verbunden. Die Widerstände dienen dazu, bei geöffnetem Schalter S12, S1n, S22, S2n den Gate-Anschluß auf GROUND bzw. Vdd zu ziehen, damit die jeweiligen Inverter IN2 bis INn gesperrt sind. So sind die Transistoren T12, T22, T1n, T2n dann hochohmig.

Die Feineinstellung der Gesamtimpedanz erfolgt über die Auswahl der Größe der Transistoren der zusätzlichen Inverter IN2, INn. Diese werden bevorzugt gewichtet und betragen etwa das 1, 2, 3, 4,... 2ⁿ-fache der Größe der Transistoren T11, T12 des Inverters IN1.

Am Ausgang Q der Treiberschaltung liegt eine 50-Ohm-Leitung mit einem Abschlußwiderstand R3 von bevorzugt ebenfalls 50 Ohm an. Der (50 Ohm-) Widerstand R3 ist mit einer Referenzspannung Vref verbunden.

Die am Ausgangswiderstand R3 abfallende Ausgangsspannung Uout ist abhängig von der Anzahl der parallel angeordneten Inverter IN1, IN2, ... INn. Über eine geeignete Zu- bzw. Wegschaltung der parallel angeordneten Inverter IN2, INn über die Schalter S12, S1n, S22, S2n können ein konstanter Ausgangsstrom und ein konstanter Ausgangswiderstand der Treiberschaltung bereitgestellt werden. Dabei werden bei Zuschalten eines Inverters IN2, INn der Ausgangsstrom erhöht und der Ausgangswiderstand verringert, da der weitere Inverter einen zusätzlichen, am Ausgangsknoten Q anliegenden Strompfad zur Verfügung stellen. Wenn somit aufgrund geänderter Transistoreigenschaften der Ausgangswiderstand ansteigt, kann dies durch Hinzuschalten eines weiteren Inverters kompensiert werden. Ebenso kann durch Wegschalten eines Inverters ein sich verringernder Ausgangswiderstand kompensiert werden.

Die dargestellte Schaltung zeichnet sich des weiteren dadurch aus, daß sie mit extrem kleinen Versorgungsspannungen mit Vdd von 1 ... 1,8 Volt auskommt. Hierdurch lassen sich sehr schnelle Schaltungen mit einer Taktfrequenz von bis zu mehreren Gigahertz, wie sie für moderne Technologien benötigt werden, verwirklichen.

Der dargestellte Hochgeschwindigkeitsausgangstreiber wird bevorzugt zur Verbindung zweier Schaltungsanordnungen auf einer Leiterplatte mittels einer 50-Ohm-Leitung benutzt. Er stellt ein Interface zu weiteren Schaltungen bereit.

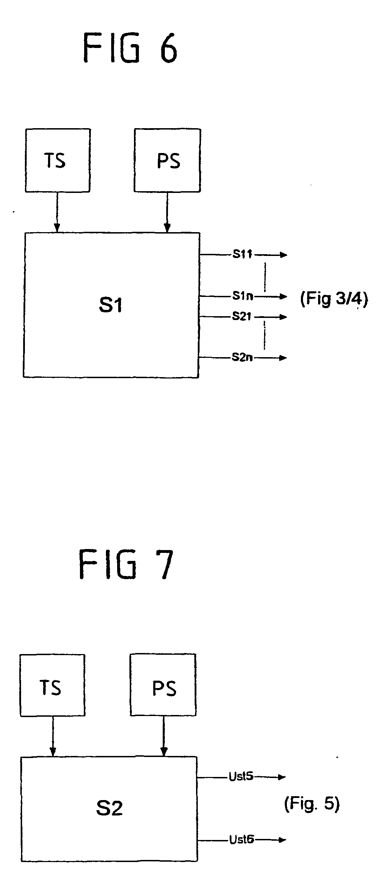

Eine Steuerung der in Figur 3 dargestellten Schalter erfolgt über eine digitale Steuereinheit gemäß Figur 6. Die Steuereinheit S1 ist mit einem Temperatursensor TS und einem Prozeßsensor PS verbunden, die analoge Eingangssignale an die Steuereinheit S1 abgeben. Der Temperatursensor TS liefert dabei ein Eingangssignal an die Steuereinheit S1, das ein Maß für die Temperatur der Transistoren T11, T21 des Inverters IN1 darstellt. Beispielsweise ist der Temperatursensor in unmittelbarer Nähe zu dem CMOS-Inverter auf einem gemeinsamen Substrat angeordnet.

Der Prozeßsensor PS liefert ein Eingangssignal, das ein Maß für Prozeßparameter der Transistoren darstellt. Der Prozeßsensor PS mißt beispielsweise die Ausgangsimpedanz bzw. den Ausgangsstrom eines vergleichbaren Transistors und gibt ein entsprechendes Signal an die Steuereinheit S1 ab. Diese wiederum erzeugt darauf geeignete Steuersignale für die Schalter S12, S1n, S22, S2n. Der Prozesssensor kann auch zusammen mit dem Temperatursensor eine Einheit bilden.

Aufgrund dieser Eingangssignale generiert die Steuereinheit S1 Steuersignale für die Schalter S11, S1n, S21, S2n, mit denen die Schalter betätigt und die jeweiligen Inverter IN2 bis INn zu- oder weggeschaltet werden.

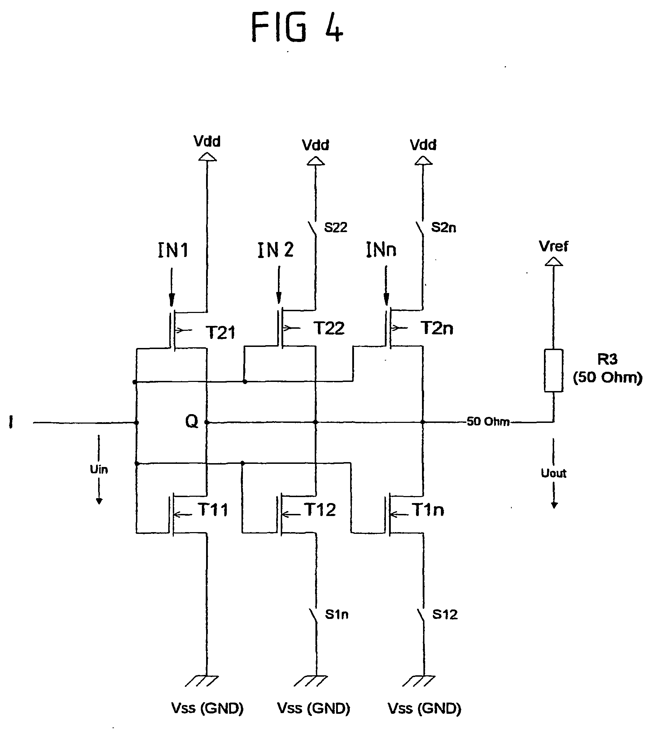

Der Hochgeschwindigkeitsausgangstreiber der Figur 4 entspricht im wesentlichen dem Treiber der Figur 3, so daß auf die dortigen Ausführungen verwiesen wird. Der Unterschied besteht darin, daß die Schalter S12, S1N und S22, S2n statt der Gate-Anschlüsse die Source-Anschlüsse der Transistoren T12, T22, T1n, T2n steuern. Die Widerstände R12, R1n, R22, R2n gemäß Figur 3 entfallen dabei. Eine eventuelle Gewichtung der Größe der Transistoren erfolgt unmittelbar über die Wahl der Transistoren.

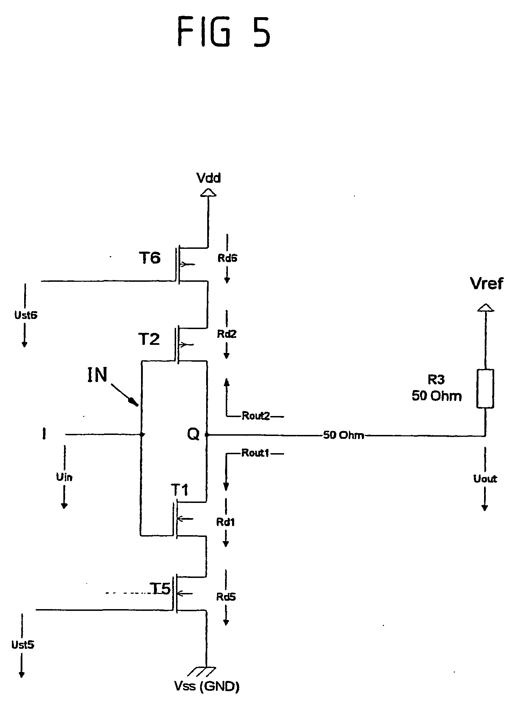

In Figur 5 ist ein alternatives Ausführungsbeispiel der Erfindung dargestellt, in dem eine analoge Steuerung eines Inverters IN erfolgt. Der Inverter IN selbst ist wie in Bezug auf die Figur 3 beschrieben ausgeführt und weist einen n-Kanal Transistor T1 und einem p-Kanäl Transistor T2 auf. Allerdings ist nun zwischen dem Source-Anschluß des Transistors T2 und der Betriebsspannung Vdd ein weiterer p-Kanal Transistor T6 in Reihe geschaltet, dessen Gate-Anschluß mit einer Steuerspannung Ust6 beaufschlagt wird. In entsprechender Weise ist zwischen den Source-Anschluß des Transistors T1 und dem Potential Vss (GROUND) ein weiterer n-Kanal Transistor T5 geschaltet, dessen Gate-Anschluß mit einer Steuerspannung Ust5 beaufschlagt wird.

Je nach am Eingangsknoten I anliegender Eingangsspannung Uin sind entweder die Transistoren T2 und T6 oder T1 und T5 leitend, wobei sich die jeweiligen, an den einzelnen Transistoren anfallenden Widerstände Rd2, Rd6 und Rd1, Rd5 zu Ausgangswiderständen Rout2 des oberen Armes und Rout1 des unteren Armes addieren.

Wenn am Knoten I ein HIGH-Pegel anliegt, sperrt der Transistor T2 und wird der Strom und der Ausgangswiderstand durch die Summe der Source-Drain-Widerstände Rd1, Rd5 von T1 und T5 bestimmt (Rout1 = Rd1 + Rd5). Am Ausgang Q liegt dann ein LOW-Pegel an.

Der zusätzliche Transistor T5 wird nun groß gewählt und ganz durchgesteuert, so daß der Gesamtwiderstand Rout1 dieses Zweiges im wesentlichen von Rd5 bestimmt wird. Durch die Steuerspannung Ust5 kann dann der Widerstand bzw. Stromfluß des Inverters gesteuert werden.

Unter der Voraussetzung, daß die anliegenden Spannungen klein sind, was bei den angegebenen Versorgungsspannungen von Vdd zwischen 1V und 1,8 V der Fall ist, wird der Transistor T5 im Triodenbereich betrieben, das heißt er stellt einen linearen Widerstand dar. Damit ist eine einfache Steuerung der Ausgangsimpedanz des Treibers möglich.

Für den Fall, daß am Knoten I ein LOW-Pegel anliegt, sind die Verhältnisse entsprechend umgekehrt.

Zur Steuerung der Spannungen Ust5 und Ust6 ist eine Steuereinheit S2 gemäß Figur 7 vorgesehen. Die Steuereinheit S2 ist wiederum mit den Ausgangssignalen eines Temperatursensors TS und eines Prozeßsensors PS verbunden. Im Unterschied zur Steuereinheit der Figur 6 werden jedoch analoge Ausgangssignale Ust5 und Ust6 erzeugt.

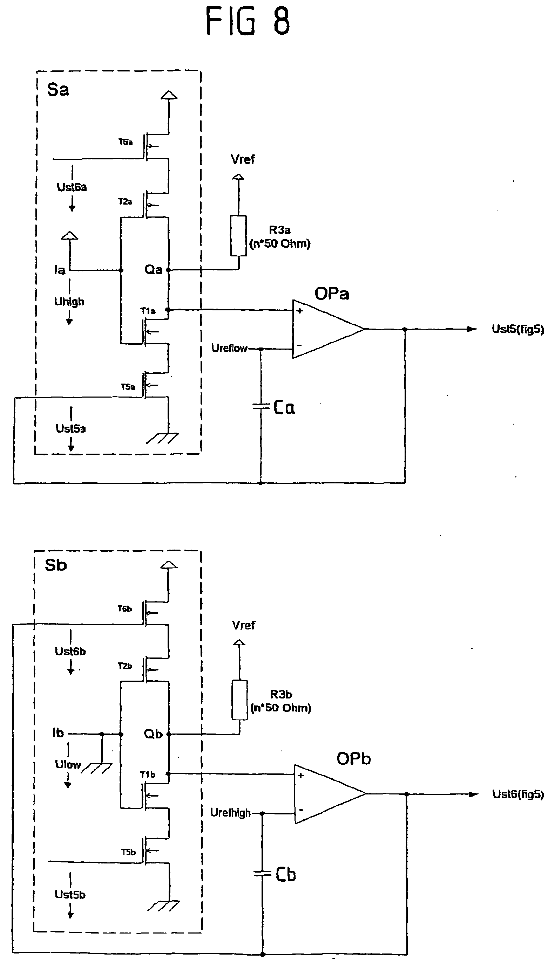

In der Figur 8 ist eine Weiterbildung der Erfindung dargestellt, in der nicht lediglich eine Steuerung der Ausgangsparameter des Inverters IN erfolgt, sondern eine Regelung. Dabei sind zur Erzeugung der Steuerspannungen Ust5 und Ust6 für die Schaltung gemäß Figur 5 zwei Spiegelschaltungen Sa und Sd vorgesehen. Die Spiegelschaltungen Sa und Sd sind derart aufgebaut, daß ihre Elemente den Elementen der eigentlichen Treiberschaltung gemäß Figur 5 entsprechen. Entsprechende Elemente der Spiegelschaltung sind zusätzlich mit dem Buchstaben "a" bzw. "b" bezeichnet.

Dabei können die Spiegelelemente der Spiegelschaltung Sa, Sb entweder die gleiche Größe wie die entsprechenden Elemente der Treiberschaltung aufweisen oder es kann eine Skalierung der Spiegelelemente vorgesehen sein, um die Stromaufnahme der Spiegelschaltung zu reduzieren. Bei einem Skalierungsfaktor n, um den die Stromaufnahme der Spiegelschaltung reduziert wird, ohne jedoch deren Eigenschaften zu ändern, sind die Transistoren T2a, T6a, T1a und T5a der Spiegelschaltung Sa um den Faktor 1/n kleiner und der Widerstand R3a um den Faktor n größer als die entsprechenden Teile des Ausgangstreibers der Figur 5. Entsprechendes gilt für die Elemente der Spiegelschaltung Sb.

Der Knoten Ia bzw. Ib der Spiegelschaltungen Sa, Sb wird auf den jeweiligen Logikpegel (HIGH, LOW) gelegt. Am Ausgang Qa bzw. Qb liegt jeweils das invertierte, verstärkte Signal vorliegt.

Der Ausgang Qa bzw. Qb ist mit dem nicht invertierten Eingang eines Operationsverstärkers OPa bzw. OPb verbunden. Der invertierte Eingang des Operationsverstärkers OPa, OPb ist über einen Kondensator Ca bzw. Cb mit dem Gate-Anschluß des Transistors T5a bzw. T6b verbunden. Der Ausgang des Operationsverstärkers ist direkt mit dem Gate-Anschluß des Transistors T5a bzw. T6b verbunden. Des weiteren stellt der Ausgang des Operationsverstärkers OPa bzw. OPb die Steuerspannung Ust5 bzw. Ust6 für den Treiber der Figur 5 bereit.

Der jeweilige Operationsverstärker OPa, OPb regelt die Steuerspannung Ust5a, Ust6b auf einen Wert, daß sich der gewünschte Ausgangspegel an Qa bzw. Qb einstellt. Die Vorgabe (Sollwert) erfolgt jeweils durch die Spannung Ureflow bzw. Urefhigh am invertierten Eingang des Operationsverstärkers.

Da die jeweilige Steuerspannung auch den eigentlichen Treiber gemäß Figur 5 steuert, ergeben sich am Ausgang Q des Treibers die gleichen Ausgangsspannungen wie in der Spiegelschaltung an Qa, Qb.

Die Steuerspannungen Ust6a in dem Schaltungsteil Sa und Ust5b in dem Schaltungsteil Sb sind nicht relevant, da der jeweils vorgeschaltete Transistor T2a in Sa und T1b in Sb gesperrt ist. Die Transistoren T6a und T5b können somit auch gesperrt sein oder entfallen.

Die Erfindung beschränkt sich in ihrer Ausführung nicht auf die vorstehend dargestellten Ausführungsbeispiele. Wesentlich für die Erfindung ist allein, daß Schaltungsmittel vorgesehen sind, die den Ausgangsstrom und den Ausgangswiderstand eines Hochgeschwindigkeitsausgangstreibers in Abhängigkeit von Eingangsparametern auf einen im wesentlichen konstanten Wert steuern oder regeln, wobei eine Zuschaltung oder Wegschaltung von zusätzlichen, in den Treiber integrierten Transistoren erfolgt.

## Patentansprüche

1. Hochgeschwindigkeitsausgangstreiber mit
- mindestens einem als Verstärker für hochfrequente digitale Signale dienenden CMOS-Inverter (IN), der einen n-Kanal Transistor (T1) und einen dazu in Reihe geschalteten, komplementären p-Kanal Transistor (T2) aufweist,
- Schaltungsmitteln (Sa, Sb), die den Ausgangsstrom und den Ausgangswiderstand des Treibers auf einen im wesentlichen konstanten Wert steuern oder regeln, und mit
- zusätzlichen Transistoren (T5, T6, Ust6), die die Schaltungsmittel (Sa, Sb) zur Steuerung oder Regelung des Ausgangsstroms und des Ausgangswiderstands des Treibers dem CMOS-Inverter (IN) über analoge Steuersignale (Ust5, Ust6) in Reihe zuschalten, wobei mindestens ein zusätzlicher Transistor (T5) in Reihe mit dem n-Kanal Transistor (T1) und mindestens ein zusätzlicher Transistor (T6) in Reihe mit dem p-Kanal Transistor (T2) des Inverters (IN) geschaltet ist,
**dadurch gekennzeichnet,**
**daß** für jeden zusätzlichen Transistor (T5, T6) eine gesonderte, unabhängige Regelschaltung in Form einer geregelten Spiegelschaltung (Sa, Sb) vorgesehen ist, die den Arbeitspunkt des jeweiligen zusätzlichen Transistors (T5; T6) regelt.

2. Treiber nach Anspruch 1, **dadurch gekennzeichnet, daß** die Elemente der Spiegelschaltung (Sa, Sb) jeweils den Elementen der Treiberschaltung entsprechen oder gegenüber diesen um einen bestimmten Faktor (n) skaliert sind.

3. Treiber nach Anspruch 1 oder 2, **dadurch gekennzeichnet, daß** jede Spiegelschaltung aufweist:
- einen CMOS-Inverter, der einen n-Kanal Transistor (T1a, T1b) und einen dazu in Reihe geschalteten, komplementären p-Kanal Transistor (T2a, T2b) aufweist,
- mindestens einen zusätzlichen Transistor (T5a, T6b), der in Reihe mit einem der Transistoren (T1a, T2b) des Inverters geschaltet ist.

4. Treiber nach Anspruch mindestens einem der vorangehenden Ansprüche, **dadurch gekennzeichnet, daß** die Spiegelschaltung (Sa, Sb) jeweils einen Operationsverstärker (OPa, OPb) enthält, der die Steuerspannung (Usta, Ustb) für die Spiegelschaltung (Sa, Sb) auf einen Wert regelt derart, daß sich der gewünschte Ausgangspegel am Ausgang (Qa, Qb) der Spiegelschaltung (Sa, Sb) und damit auch am Ausgang (Q) des Treibers einstellt.

5. Treiber nach mindestens einem der vorangehenden Ansprüche, **dadurch gekennzeichnet, daß** der zusätzliche Transistor (T5a, T5b, T6a, T6b) jeweils im Triodenbereich betrieben wird.

## Claims

1. High-speed output driver having
- at least one CMOS inverter (IN) which is used as an amplifier for radio-frequency digital signals and has an n-channel transistor (T1) and a complementary p-channel transistor (T2) that is connected in series with the latter,
- circuit means (Sa, Sb) which control or regulate the output current and the output resistance of the driver to an essentially constant value, and having
- additional transistors (T5, T6) which connect the circuit means (Sa, Sb) for controlling or regulating the output current and the output resistance of the driver in series with the CMOS inverter (IN) using analogue control signals (Ust5, Ust6), at least one additional transistor (T5) being connected in series with the n-channel transistor (T1) and at least one additional transistor (T6) being connected in series with the p-channel transistor (T2) of the inverter (IN),
**characterized in that**
a separate independent regulating circuit in the form of a regulated mirror circuit (Sa, Sb) which regulates the operating point of the respective additional transistor (T5, T6) is provided for each additional transistor (T5, T6).

2. Driver according to Claim 1, **characterized in that** the elements of the mirror circuit (Sa, Sb) each correspond to the elements of the driver circuit or are scaled by a particular factor (n) relative to the latter.

3. Driver according to Claim 1 or 2, **characterized in that** each mirror circuit has:
- a CMOS inverter which has an n-channel transistor (T1a, T1b) and a complementary p-channel transistor (T2a, T2b) that is connected in series with the latter,
- at least one additional transistor (T5a, T6b) which is connected in series with one of the transistors (T1a, T2b) of the inverter.

4. Driver according to at least one of the preceding claims, **characterized in that** the mirror circuit (Sa, Sb) respectively contains an operational amplifier (OPa, OPb) which regulates the control voltage (Usta, UStb) for the mirror circuit (Sa, Sb) to a value such that the desired output level is set at the output (Qa, Qb) of the mirror circuit (Sa, Sb) and thus also at the output (Q) of the driver.

5. Driver according to at least one of the preceding claims, **characterized in that** the additional transistor (T5a, T5b, T6a, T6b) is respectively operated in the triode region.

## Revendications

1. Étage de sortie à grande vitesse comportant :
- au moins un inverseur CMOS (IN) qui sert d'amplificateur pour des signaux numériques à haute fréquence et qui comporte un transistor à canal n (T1) et un transistor à canal p (T2) complémentaire et branché en série avec le précédent,
- des moyens de commutation (Sa, Sb) qui commandent ou régulent le courant de sortie et la résistance de sortie de l'étage de sortie sur une valeur globalement constante, et
- des transistors supplémentaires (T5, T6) que les moyens de commutation (Sa, Sb) pour la commande ou la régulation du courant de sortie et de la résistance de sortie de l'étage de sortie branchent en série avec l'inverseur CMOS (IN) par l'intermédiaire de signaux de commande analogiques (Ust5, Ust6), au moins un transistor supplémentaire (T5) étant branché en série avec le transistor à canal n (T1) et au moins un transistor supplémentaire (T6) étant branché en série avec le transistor à canal p (T2) de l'inverseur (IN),
**caractérisé par le fait que**,
pour chaque transistor supplémentaire (T5, T6), il est prévu un circuit de régulation particulier et indépendant sous la forme d'un circuit en miroir régulé (Sa, Sb) qui régule le point de fonctionnement du transistor supplémentaire respectif (T5, T6).

2. Étage de sortie selon la revendication 1, **caractérisé par le fait que** les éléments du circuit en miroir (Sa, Sb) correspondent à chaque fois aux éléments de l'étage de sortie ou sont dans un rapport avec celui-ci égal à un certain facteur (n).

3. Étage de sortie selon la revendication 1 ou 2, **caractérisé par le fait que** le circuit en miroir comporte :
- un inverseur CMOS qui comporte un transistor à canal n (T1a, T1b) et un transistor à canal p (T2a, T2b) complémentaire et branché en série avec le précédent, et
- au moins un transistor supplémentaire (T5a, T6b) qui est branché en série avec l'un des transistors (T1a, T2b) de l'inverseur.

4. Étage de sortie selon au moins l'une des revendications précédentes, **caractérisé par le fait que** le circuit en miroir (Sa, Sb) contient à chaque fois un amplificateur opérationnel (OPa, OPb) qui régule la tension de commande (Usta, Ustb) pour le circuit en miroir (Sa, Sb) sur une valeur telle que le niveau de sortie souhaité à la sortie (Qa, Qb) du circuit en miroir (Sa, Sb) et donc aussi à la sortie (Q) de l'étage de sortie est réglé.

5. Étage de sortie selon au moins l'une des revendications précédentes, **caractérisé par le fait que** le transistor supplémentaire (T5a, T5b, T6a, T6b) fonctionne à chaque fois dans le mode triode.
